# EUROPÄISCHE PATENTANMELDUNG

(11) **EP 3 951 501 A1**
(43) Veröffentlichungstag der Anmeldung: **09.02.2022**
(21) Anmeldenummer: 21179939.0
(22) Anmeldetag: 17.06.2021
(51) Int. Cl.: G03F 7/20

(54) **VERFAHREN ZUR HERSTELLUNG ODER EINSTELLUNG EINER PROJEKTIONSBELICHTUNGSANLAGE**

(30) Priorität: 04.08.2020 DE 102020209784
(71) Anmelder: Carl Zeiss SMT GmbH, 73447 Oberkochen (DE)
(72) Erfinder: Freimann, Rolf, 73431 Aalen (DE)
(74) Vertreter: Carl Zeiss SMT GmbH

(57) **Zusammenfassung**

Die vorliegende Erfindung betrifft ein Verfahren zur Herstellung oder Einstellung einer Projektionsbelichtungsanlage (1), die eine Lichtquelle (2), ein Beleuchtungssystem (3) und ein Projektionsobjektiv (4) umfasst und verwendet wird, um die Strukturen einer Maske (5) abzubilden, wobei das Projektionsobjektiv mehrere optische Komponenten umfasst, die justiert werden können, um Abbildungseigenschaften der Projektionsbelichtungsanlage einzustellen, wobei das Verfahren die Bestimmung einer ersten Abbildungseigenschaft umfasst, die optimiert werden soll, wobei zur Optimierung der ersten Abbildungseigenschaft die Einstellung des Beleuchtungssystems (2) und / oder die Struktur der Maske (5) und / oder mindestens ein erstes einstellbares optisches Element (14) des Projektionsobjektivs hinsichtlich der Form einer seiner mindestens einen optisch wirksamen Fläche oder der optische Wirkung zur Einstellung einer optimierten Wellenfront des Arbeitslichts optimiert werden, wobei die Optimierung von Beleuchtungssystem, Maske und / oder optischem Element des Projektionsobjektivs so erfolgt, dass mindestens ein weiterer Manipulator (12, 15 - 17) der Projektionsbelichtungsanlage zur Manipulation der Wellenfront bei der Optimierung der ersten Abbildungseigenschaft in der Mittellage seines Manipulationsbereichs eingestellt wird.

## Beschreibung

### HINTERGRUND DER ERFINDUNG

### GEBIET DER ERFINDUNG

Die vorliegende Erfindung betrifft ein Verfahren zur Herstellung oder Einstellung einer Projektionsbelichtungsanlage, die eine Lichtquelle, ein Beleuchtungssystem und ein Projektionsobjektiv umfasst und verwendet wird, um Strukturen einer Maske abzubilden, und insbesondere ein Verfahren zur Optimierung von Abbildungseigenschaften.

### STAND DER TECHNIK

Projektionsbelichtungsanlagen werden in der Mikrolithographie für die Herstellung von mikro - oder nanostrukturierten Bauteilen der Mikroelektronik oder Mikrosystemtechnik eingesetzt. Aufgrund der fortschreitenden Miniaturisierung entsprechender Bauteile besteht das Erfordernis Strukturen mit immer kleineren Dimensionen in geeigneter Weise zuverlässig abzubilden. Entsprechend werden bereits Projektionsbelichtungsanlagen eingesetzt, die mit extrem ultraviolettem Licht (EUV - Licht) betrieben werden, um das Auflösungsvermögen entsprechender Projektionsbelichtungsanlagen weiter zu verbessern.

Darüber hinaus sind weiterhin Optimierungsverfahren bekannt, die die Einstellung geeigneter Beleuchtungssettings von Beleuchtungssystemen von Projektionsbelichtungsanlagen und die Gestaltung der Strukturen von Masken betreffen, um Strukturen mit kleinsten Strukturbreiten und geringen Strukturabständen zuverlässig abbilden zu können. Derartige Optimierungsverfahren sind unter dem Stichwort Auflösungsverbesserungstechniken (resolution enhancement techniques RET) bekannt und in den US Patenten US 9 588 438 B2 sowie US 9 041 908 B2 beschrieben, deren Offenbarungsgehalt hiermit ausdrücklich und vollständig in den Offenbarungsgehalt der vorliegenden Anmeldung mit aufgenommen wird.

In diesen Dokumenten sind unter anderem Quellen - Masken - Optimierungsverfahren (source mask optimization SMO), ein Quellen - Masken - Objektiv - Optimierungsverfahren (source mask lens optimization SMLO), ein Quellen - Masken - Pupillen - Optimierungsverfahren (source mask pupil optimization SMPO), ein Masken - Wellenfront - Optimierungsverfahren (mask wavefront optimization MWO), ein Quellen - Masken - Wellenfront - Optimierungsverfahren (source mask wavefront optimization SMWO) und ein Quellen - Masken - Polaisierung - Wellenfront - Optimierungsverfahren (source mask polarization wavefront optimization SMPWO) beschrieben, die auch in dem Verfahren der vorliegenden Erfindung zum Einsatz kommen. Entsprechend stellt die vorliegende Erfindung eine Weiterentwicklung der in den oben genannten US Patenten beschriebenen Verfahren dar.

### OFFENBARUNG DER ERFINDUNG

### AUFGABE DER ERFINDUNG

Es ist deshalb Aufgabe der vorliegenden Erfindung eine weitere Verbesserung der Abbildungseigenschaften von Projektionsbelichtungsanlagen zu erzielen. Hierbei soll ein entsprechendes Verfahren einfach und zuverlässig mit vertretbarem Aufwand durchführbar sein.

### TECHNISCHE LÖSUNG

Diese Aufgabe wird durch ein Verfahren zur Herstellung oder Einstellung einer Projektionsbelichtungsanlage mit den Merkmalen des Anspruchs 1 gelöst. Vorteilhafte Ausgestaltungen der Erfindung sind Gegenstand der abhängigen Ansprüche.

Die Erfindung schlägt vor zunächst eine erste Abbildungseigenschaften zu bestimmen, die optimiert werden soll.

Die erste Abbildungseigenschaft kann beispielsweise die Optimierung der Korrektur maskenabhängiger Aberrationen, insbesondere die Optimierung der Abbildung kritischer Strukturbestandteile bzw. die Optimierung der Auflösung bestimmter Strukturen oder die Optimierung der Korrektur von von Strukturbreiten oder Strukturabständen bedingten Aberrationen umfassen.

Zur Optimierung der ersten Abbildungseigenschaft wird zunächst die Einstellung des Beleuchtungssystems optimiert. Alternativ oder zusätzlich kann die Struktur der Maske zur Optimierung der ersten Abbildungseigenschaften ebenfalls optimiert werden. Weiterhin ist alternativ oder zusätzlich eine Optimierung der Wellenfront des Arbeitslichts durch mindestens ein erstes einstellbares, optisches Element des Projektionsobjektivs vorgesehen, wobei das erste einstellbare, optische Element des Projektionsobjektivs hinsichtlich der Form einer seiner mindestens einen optisch wirksamen Fläche oder hinsichtlich seiner optischen Wirkung optimiert wird.

Für diese Optimierung der ersten Abbildungseigenschaften können zunächst Simulationen und / oder Berechnungen durchgeführt werden, wobei verschiedene Verfahren aus dem Stand der Technik eingesetzt werden können. Hier können entsprechende Auflösungsverbesserungstechniken (Resolution Enhancement Technologies RET), wie sie in den oben zitierten US Patenten beschrieben sind, eingesetzt werden. Insbesondere können Verfahren zur optischen Korrektur des Nachbarschaftseffekts (optical proximity correction OPC), Anwendung von Phasenverschiebemasken (phase-shift masks PSM), Anwendung von Sub - Auflösung - Hilfsstrukturen (sub resolution assist features SRAF), Quellen - Masken - Optimierung (source mask optimization SMO), Quellen - Masken - Objektiv - Optimierung (source mask lens optimization SMLO), Quellen - Masken - Pupillen - Optimierung (source mask pupil optimization SMPO), Masken - Wellenfront - Optimierung (mask wavefront optimization MWO), Quellen - Masken - Wellenfront - Optimierung (source mask wavefront optimization SMWO) und Quellen - Masken - Polarisierung - Wellenfront - Optimierung (source mask polarization wavefront optimization SMPWO) eingesetzt werden.

Des Weiteren erfolgt die Optimierung von Beleuchtungssystem und / oder Maske und / oder einem optischem Element des Projektionsobjektivs hinsichtlich der ersten Abbildungseigenschaft so, dass ferner mindestens ein Manipulator, vorzugsweise mehrere oder alle Manipulatoren der Projektionsbelichtungsanlage zur Manipulation der Wellenfront, die nicht der Einstellung des Beleuchtungssystems und / oder des ersten einstellbaren optischen Elements der Projektionsobjektivs dienen, bei der Optimierung der ersten Abbildungseigenschaften in der Mittellage ihres Manipulationsbereichs eingestellt werden. Die Optimierung von Beleuchtungssystem und / oder Maske und / oder einem ersten einstellbaren optischen Element des Projektionsobjektivs erfolgt somit mit der Randbedingung, dass zusätzliche Manipulatoren in der Mittellage des Manipulationsbereichs eingestellt werden. Dadurch wird erreicht, dass nach der Optimierung der ersten Abbildungseigenschaften der maximale Manipulationsbereich für eine weitere Manipulation der Wellenfront zur Korrektur von weiteren Abbildungseigenschaften zur Verfügung steht. Auf diese Weise ist es insbesondere dann, wenn während des Betriebs der Projektionsbelichtungsanlage beispielsweise durch die Erwärmung von optischen Elementen zusätzliche Aberrationen eingeführt werden, möglich, diese durch weitere Manipulation der Wellenfront zu korrigieren.

Das mindestens eine optische Element des Projektionsobjektivs, das zur Optimierung der Wellenfront bei der Optimierung der ersten Abbildungseigenschaften eingesetzt werden kann, kann ein Spiegel sein, von dem die Form der optisch wirksamen Fläche, also die Spiegelfläche, verändert wird. Insbesondere kann das entsprechende optische Element ein deformierbarer Spiegel sein, der Aktuatoren aufweist, die eine Formänderung der Spiegelfläche ermöglichen. Weiterhin ist es auch möglich, dass das optische Element des Projektionsobjektivs, das zur Manipulation der Wellenfront verwendet wird, ein refraktives optisches Element ist, von dem die Form der optisch wirksamen Fläche und / oder der Brechungsindex verändert werden, beispielsweise durch lokale Erwärmung oder dergleichen.

Falls bei der Optimierung der ersten Abbildungseigenschaft ein deformierbarer Spiegel eingesetzt wird, können der deformierbare Spiegel bzw. die entsprechenden Aktuatoren so eingestellt werden, dass nach der Einstellung der Form der optisch wirksamen Fläche, also der Spiegelfläche, für die optimierte erste Abbildungseigenschaft die Aktuatoren in einer Mittellage bezüglich des Deformationsbereichs vorliegen, sodass eine weitergehende Deformation des deformierbaren Spiegels mit maximalem Betätigungsbereich der Aktuatoren möglich ist.

Die weiteren Manipulatoren der Projektionsbelichtungsanlage zur Manipulation der Wellenfront, die bei der Optimierung der ersten Abbildungseigenschaften in der Mittellage des Manipulationsbereichs eingestellt werden, können weitere optische Elemente sein, die in ihrer Position und / oder Ausrichtung zur Manipulation der Wellenfront in einem Bewegungsbereich verändert werden können. Bei einer EUV - Projektionsbelichtungsanlage können dies beispielsweise weitere Spiegel des Projektionsobjektivs sein, die in ihrer Position und / oder Ausrichtung veränderbar sind.

Um bei der Optimierung der ersten Abbildungseigenschaft die weiteren Manipulatoren in einer Mittellage des Manipulationsbereichs einstellen zu können, kann das Verfahren weiterhin einen Schritt der Erfassung sämtlicher Manipulatoren und die Bestimmung des gesamten Manipulationsbereiches der Manipulatoren umfassen.

Die Manipulationsbereiche der weiteren Manipulatoren können für verschiedene Abbildungsfehler, insbesondere entsprechend verschiedener Zernike - Polynome, bestimmt werden.

### KURZBESCHREIBUNG DER FIGUREN

Die beigefügten Zeichnungen zeigen in rein schematischer Weise in
- Figur 1: eine Darstellung einer EUV - Projektionsbelichtungsanlage,
- Figur 2: eine Darstellung des Ablaufs eines erfindungsgemäßen Verfahrens,
- Figur 3: eine Darstellung eines deformierbaren Spiegels, wie er in der Projektionsbelichtungsanlage aus Figur 1 eingesetzt werden kann,
- Figur 4: eine Darstellung der Intensitätsverteilung in einer Pupillenebene für ein Beleuchtungssetting für die EUV - Projektionsbelichtungsanlage aus Figur 1,
- Figur 5: eine Darstellung eines Teilbereichs einer Maske mit einer Subauflösungshilfsstruktur, wie sie in der Projektionsbelichtungsanlage aus Figur 1 Verwendung findet, und in
- Figur 6: eine Darstellung der Manipulationsbereiche für verschiedene Abbildungsfehler gemäß Zernike - Polynomen für eine Projektionsbelichtungsanlage aus Figur 1.

### AUSFÜHRUNGSBEISPIELE

Weitere Vorteile, Kennzeichen und Merkmale der vorliegenden Erfindung werden bei der nachfolgenden detaillierten Beschreibung der Ausführungsbeispiele ersichtlich. Allerdings ist die Erfindung nicht auf diese Ausführungsbeispiele beschränkt.

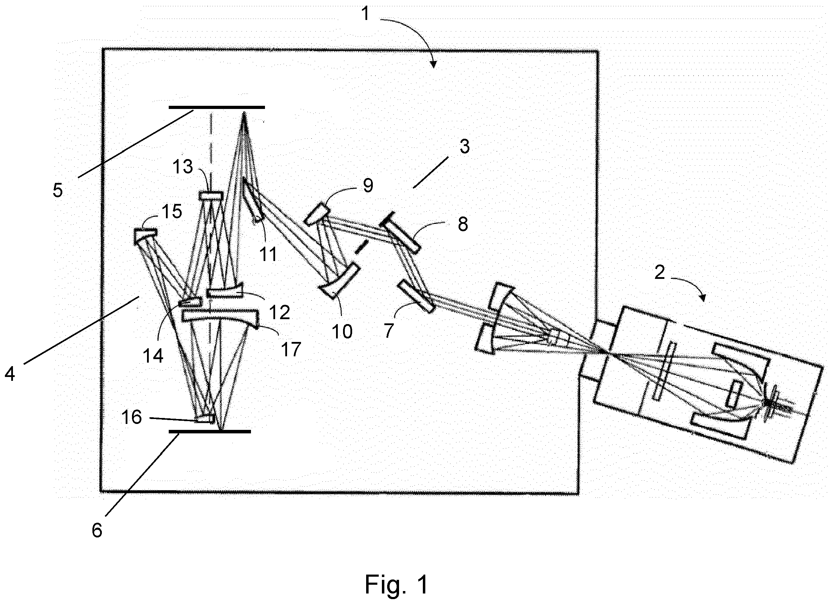

Die Figur 1 zeigt eine Darstellung einer EUV - Projektionsbelichtungsanlage 1, für deren Herstellung bzw. Einstellung die vorliegende Erfindung verwendet werden kann. Die in der Figur 1 dargestellte EUV - Projektionsbelichtungsanlage 1 umfasst eine Lichtquelleneinheit 2 sowie ein Beleuchtungssystem 3 und ein Projektionsobjektiv 4, mit dem die Strukturen einer Maske 5 in verkleinernder Weise auf einen Wafer 6 abgebildet werden. Das Beleuchtungssystem 3 umfasst einen Feldfacettenspiegel 7 und einen Pupillenfacettenspiegel 8 sowie einen ersten Teleskopspiegel 9 und einen zweiten Teleskopspiegel 10 und einen Umlenkspiegel 11, mit denen das EUV - Licht der Lichtquelle 2 aufbereitet wird, um die Maske 5 zu beleuchten.

Das Projektionsobjektiv 4 umfasst sechs Spiegel 12 bis 17, wobei einer dieser Spiegel als erstes einstellbares optisches Element ausgebildet sein kann, beispielsweise in Form eines deformierbaren Spiegels, sodass durch die Einstellung der Oberflächenform des Spiegels eine gewünschte Wellenfront des EUV - Lichts im Projektionsobjektiv 4 erzeugt werden kann, sodass eine optimierte Abbildung der Maske 5 auf den Wafer 6 ermöglicht wird.

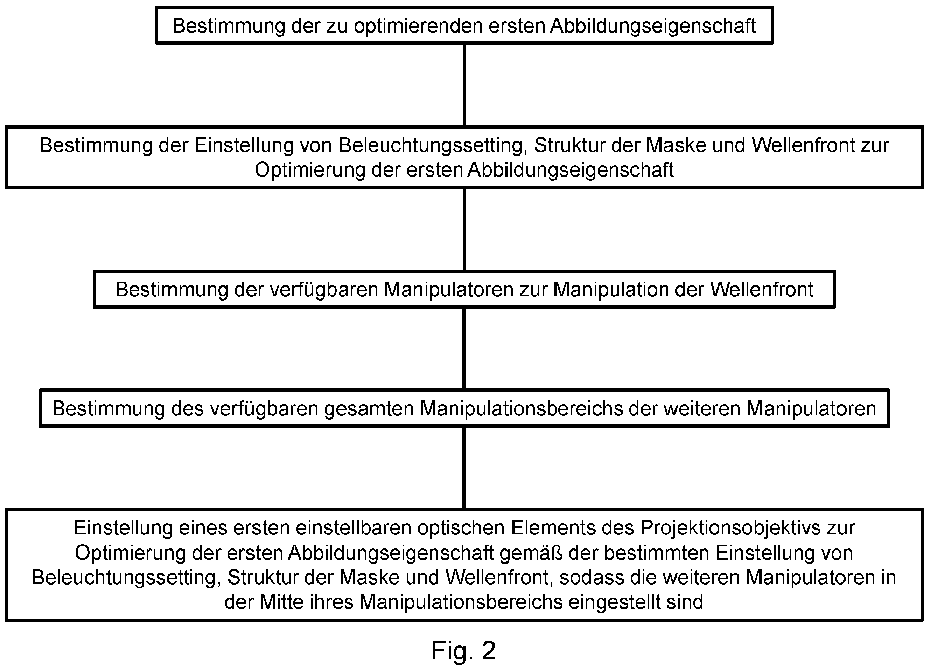

Die Figur 2 zeigt den Ablauf eines erfindungsgemäßen Verfahrens zur Einstellung der Projektionsbelichtungsanlage 1.

Zunächst wird eine erste, zu optimierende Abbildungseigenschaft bestimmt, beispielsweise die zu optimierende Abbildung bestimmter Strukturen der Maske bzw. die Korrektur von sogenannten Nachbarschaftseffekten bei der Abbildung von benachbarten Strukturen auf der Maske, wie bei der optischen Nachbarschaftskorrektur (optical proximity correction OPC).

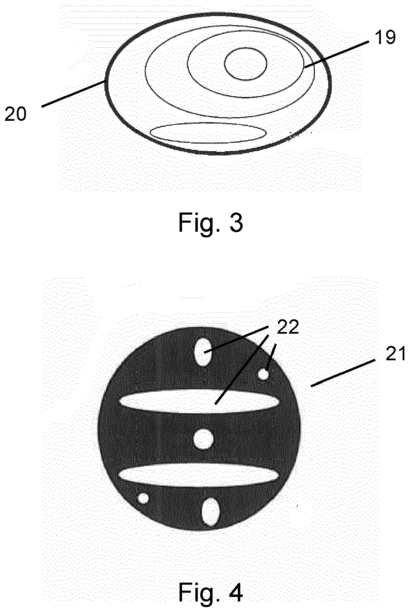

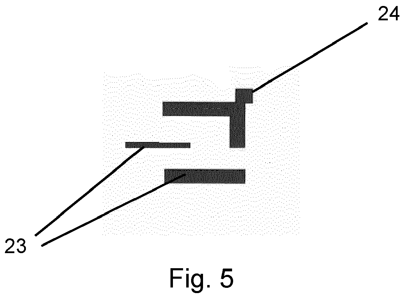

Hierzu wird zunächst durch Simulation und Berechnungen bestimmt, welche Einstellung eines Beleuchtungssettings im Beleuchtungssystem, wie dies beispielsweise in der Figur 4 dargestellt ist, vorgenommen werden sollen und welche Strukturen die Maske, wie sie beispielsweise in der Figur 5 dargestellt sind, aufweisen soll, um eine Optimierung der ersten Abbildungseigenschaften zu ermöglichen bzw. die Korrektur von sogenannten Nachbarschaftseffekten zu bewirken. Außerdem wird bestimmt, wie die optimale Wellenfront für eine derartige Optimierung der ersten Abbildungseigenschaft aussehen kann.

Nach der Simulation und Berechnung der Einstellungen von Beleuchtungssetting, Struktur der Maske und der Wellenfront werden die verfügbaren Manipulatoren zur Manipulation der Wellenfront bestimmt und es wird der gesamte verfügbare Manipulationsbereich der Manipulatoren berechnet.

Anschließend wird für ein erstes einstellbares, optisches Element des Projektionsobjektivs die entsprechende Einstellung dieses optischen Elements unter Berücksichtigung der bestimmten Einstellung von Beleuchtungssetting, Struktur der Maske und gewünschter Wellenfront so vorgenommen, dass zum einen die Optimierung der ersten Abbildungseigenschaften durch die Einstellung des ersten einstellbaren, optischen Elements und der dadurch erzeugten Wellenfrontmanipulation gewährleistet ist und dass zum anderen weitere Manipulatoren, wie weitere einstellbare optische Elemente, die in der Projektionsbelichtungsanlage vorhanden sind, in der Mitte ihres Manipulationsbereichs eingestellt werden.

Als erstes einstellbares optisches Element kann beispielsweise ein deformierbarer Spiegel 20 Verwendung finden, wie er in Figur 3 dargestellt ist. Der deformierbare Spiegel 20 kann so verformt werden, dass sich an der Spiegeloberfläche Erhöhungen und / oder Vertiefungen ergeben, wie dies beispielsweise durch die Höhenlinien 19 in der Figur 3 dargestellt ist. Mit diesem deformierbaren Spiegel 20 und der Einstellung der entsprechenden Spiegeloberfläche kann die Wellenfront so manipuliert werden, dass sie der bestimmten Einstellung der Wellenfront für die Optimierung der ersten Abbildungseigenschaften, also beispielsweise für die Korrektur von Nachbarschaftseffekten bei der Abbildung von benachbarten Strukturen der Maske entspricht. Darüber hinaus kann der deformierbare Spiegel so aufgebaut oder eingestellt werden, dass die Aktuatoren zur Einstellung der gewünschten Deformation sich in der Mittellage ihres Betätigungsbereichs befinden, sodass weitere Verformungen des deformierbaren Spiegels mit maximalem Betätigungsbereich möglich sind.

Gleichzeitig werden auch weitere Manipulatoren der Projektionsbelichtungsanlage und insbesondere des Projektionsobjektivs in der Mittellage ihres Manipulationsbereichs eingestellt, sodass auch bei diesen maximale Manipulationsbereiche gewährleistet sind. Beispielsweise können, wenn zum Beispiel bei der EUV - Projektionsbelichtungsanlage 1 der Spiegel 14 als deformierbarer Spiegel 20 ausgebildet ist, die übrigen Spiegel 12 und 15 bis1 in ihrer Position und / oder Ausrichtung variiert werden, um auf diese Weise eine Manipulation der Wellenfront zu erzeugen.

Gemäß einer vorteilhaften Ausführungsform der Erfindung wird auf Basis der Bestimmung des verfügbaren gesamten Manipulationsbereichs der Manipulatoren das erste einstellbare, optische Element, also der deformierbare Spiegel 14, 20 so eingestellt, dass die übrigen Spiegel 12 und 15 bis17 sich in der Mitte ihres Manipulationsbereichs befinden, sodass ein Maximum an weiteren Manipulationsmöglichkeiten für den weiteren Betrieb der Produktionsbelichtungsanlage und der Korrektur weiterer Abbildungseigenschaften gegeben sind, wenn also beispielsweise Anpassungen der Wellenfront aufgrund von sich erwärmenden Spiegeln oder dergleichen erforderlich sind. Ist der Manipulationsbereich durch den Positionier - und / oder Ausrichtungsbereich der Spiegel 12 und 15 bis 17 gegeben, so befindet sich die Mitte des Manipulationsbereichs entsprechend bei der Mittellage des jeweiligen Positionier - und / oder Ausrichtungsbereichs.

Anstelle eines deformierbaren Spiegels, der über eine Vielzahl von Aktuatoren über die gesamte Spiegelfläche in bestimmter Weise deformiert werden kann, kann auch ein Spiegel verwendet werden, dessen Spiegelfläche gemäß dem Ergebnis der vorliegenden Erfindung geformt wird und entsprechend fixiert ist. Entsprechend wird bei einem derartigen Spiegel dessen Form vor dem Betrieb eingestellt und die korrektur weiterer Abbildungseigenschaften während des Betriebs der Projektionsbelichtungsanlage kann durch die Einstellung weiterer Manipulatoren vorgenommen werden. Wohingegen bei einem deformierbaren Spiegel als erstes einstellbares optisches Element die entsprechende Anpassung variabel zu jeder beliebigen Zeit vorgenommen werden kann.

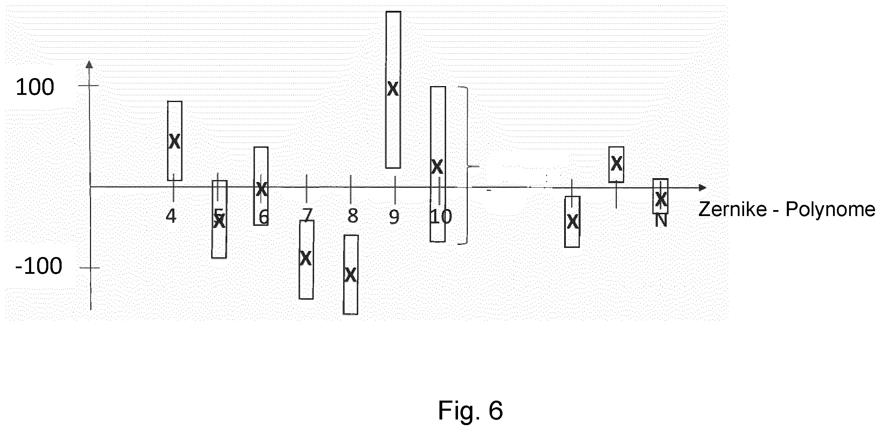

Die Figur 6 zeigt für verschiedene Abbildungsfehler gemäß den Zernike - Polynomen die unterschiedlichen Manipulationsbereiche und die Lage der eingestellten Wellenfront in den jeweiligen Manipulationsbereichen nach der Einstellung der Projektionsbelichtungsanlage gemäß der vorliegenden Erfindung durch ein entsprechendes Kreuz. Wie aus der Figur 6 deutlich wird, wird durch die Einstellung gemäß der vorliegenden Erfindung erreicht, dass weiterhin ein großer Manipulationsbereich zur Einstellung von weiteren Abbildungseigenschaften bzw. zur Korrektur von weiteren Abbildungsfehlern, die sich im Betrieb der Projektionsbelichtungsanlage ergeben können, zur Verfügung steht. Während bei dem gezeigten Ausführungsbeispiel die Gesamtheit der weiteren verfügbaren Manipulatoren so eingestellt wird, dass die damit insgesamt zu manipulierenden Abbildungseigenschaften oder Abbildungsfehler jeweils in einer Mittellage des Manipulationsbereichs liegen, kann auch ein einzelner weiterer Manipulator oder einzelne weitere Manipulatoren jeweils für bestimmte Einstellungen von Abbildungseigenschaften oder Korrekturen für Abbildungsfehler in einer entsprechenden Mittellage des Manipulationsbereichs vorgesehen werden.

Obwohl die vorliegende Erfindung anhand der Ausführungsbeispiele detailliert beschrieben worden ist, ist für den Fachmann selbstverständlich, dass die Erfindung nicht auf diese Ausführungsbeispiele beschränkt ist, sondern dass vielmehr Abwandlungen in der Weise möglich sind, dass einzelne Merkmale weggelassen oder andersartige Kombinationen von Merkmalen verwirklicht werden können, ohne dass der Schutzbereich der beigefügten Ansprüche verlassen wird. Insbesondere schließt die vorliegende Offenbarung sämtliche Kombinationen der in den verschiedenen Ausführungsbeispielen gezeigten Einzelmerkmale mit ein, sodass einzelne Merkmale, die nur in Zusammenhang mit einem Ausführungsbeispiel beschrieben sind, auch bei anderen Ausführungsbeispielen oder nicht explizit dargestellten Kombinationen von Einzelmerkmalen eingesetzt werden können.

### BEZUGSZEICHENLISTE

1 Projektionsbelichtungsanlage
2 Lichtquelleneinheit
3 Beleuchtungssystem
4 Projektionsobjektiv
5 Retikel bzw. Maske
6 Wafer
7 Feldfacettenspiegel
8 Pupillenfacettenspiegel
9 erster Teleskopspiegel
10 zweiter Teleskopspiegel
11 Umlenkspiegel
12 erster Spiegel
13 zweiter Spiegel
14 dritter Spiegel
15 vierter Spiegel
16 fünfter Spiegel
17 sechster Spiegel
19 Höhenlinien
20 deformierbarer Spiegel
21 Pupille
22 Intensitätsmaximum
23 Strukturteile
24 Subauflösungshilfsstruktur (sub resolution assistent feature SRAF)

## Patentansprüche

1. Verfahren zur Herstellung oder Einstellung einer Projektionsbelichtungsanlage (1), die eine Lichtquelle (2), ein Beleuchtungssystem (3) und ein Projektionsobjektiv (4) umfasst und verwendet wird, um Strukturen einer Maske (5) abzubilden, wobei das Projektionsobjektiv mehrere optische Komponenten umfasst, die justiert werden können, um Abbildungseigenschaften der Projektionsbelichtungsanlage einzustellen, wobei das Verfahren die Bestimmung einer ersten Abbildungseigenschaft umfasst, die optimiert werden soll, wobei zur Optimierung der ersten Abbildungseigenschaft die Einstellung des Beleuchtungssystems (2) und / oder die Struktur der Maske (5) und / oder mindestens ein erstes einstellbares optisches Element (14) des Projektionsobjektivs hinsichtlich der Form einer seiner mindestens einen optisch wirksamen Fläche oder der optische Wirkung zur Einstellung einer optimierten Wellenfront des Arbeitslichts optimiert werden,
und wobei die Optimierung von Beleuchtungssystem (2), Maske (5) und / oder optischem Element (14) des Projektionsobjektivs (4) so erfolgt, dass mindestens ein weiterer Manipulator (12, 15 - 17) der Projektionsbelichtungsanlage zur Manipulation der Wellenfront bei der Optimierung der ersten Abbildungseigenschaft in der Mittellage seines Manipulationsbereichs eingestellt wird.

2. Verfahren nach Anspruch 1,
**dadurch gekennzeichnet, dass**
das mindestens eine optische Element (14) des Projektionsobjektivs (4) ein Spiegel, von dem die Form der optisch wirksamen Fläche im Betrieb oder vorab verändert wird, insbesondere ein deformierbarer Spiegel, oder ein refraktives optisches Element ist, von dem die Form der optisch wirksamen Fläche und / oder der Brechungsindex verändert werden.

3. Verfahren nach Anspruch 2,
**dadurch gekennzeichnet, dass**
der deformierbare Spiegel (14, 20) zur Optimierung der ersten Abbildungseigenschaft so eingestellt wird, dass die Form der optisch wirksamen Fläche für die optimierte erste Abbildungseigenschaft in einer Mittellage bezüglich des Deformationsbereiches eingestellt wird.

4. Verfahren nach einem der vorhergehenden Ansprüche,
**dadurch gekennzeichnet, dass**
mehrere, insbesondere alle weiteren Manipulatoren (12, 15 - 17) der Projektionsbelichtungsanlage zur Manipulation der Wellenfront bei der Optimierung der ersten Abbildungseigenschaft in der Mittellage seines Manipulationsbereichs eingestellt werden.

5. Verfahren nach einem der vorhergehenden Ansprüche,
**dadurch gekennzeichnet, dass**
der mindestens eine weitere Manipulator der Wellenfront ein optisches Elemente (12, 15 - 17) des Projektionsobjektivs ist, das in seiner Position und / oder Ausrichtung zur Manipulation der Wellenfront in einem Bewegungsbereich verändert werden können, wobei das optische Element (12, 15 - 17) bei der Optimierung der ersten Abbildungseigenschaft in der Mittellage des Bewegungsbereichs angeordnet werden.

6. Verfahren nach einem der vorhergehenden Ansprüche,
**dadurch gekennzeichnet, dass**
die Optimierung der ersten Abbildungseigenschaft die Optimierung der Korrektur maskenabhängiger Aberrationen, insbesondere die Optimierung der Abbildung kritischer Strukturbestandteile oder die Optimierung der Auflösung bestimmter Strukturen oder die Optimierung der Korrektur von durch Strukturbreiten oder Strukturabständen bedingten Aberrationen umfasst.

7. Verfahren nach einem der vorhergehenden Ansprüche,
**dadurch gekennzeichnet, dass**
die Optimierung der ersten Abbildungseigenschaft durch mindestens eine Methode aus der Gruppe durchgeführt wird, die Auflösungsverbesserungstechniken (Resolution Enhancement Technologies RET), optische Nachbarschaftskorrektur (optical proximity correction OPC), Anwendung von Phasenverschiebemasken (phase-shift masks PSM), Anwendung von Sub - Auflösung - Hilfsstrukturen (sub resolution assist features SRAF), Quellen - Masken - Optimierung (source mask optimization SMO), Quellen - Masken - Linsen - Optimierung (source mask lens optimization SMLO), Quellen - Masken - Pupillen - Optimierung (source mask pupil optimization SMPO), Masken - Wellenfront - Optimierung (mask wavefront optimization MWO), Quellen - Masken - Wellenfront - Optimierung (source mask wavefront optimization SMWO) und Quellen - Masken - Polarisierung - Wellenfront - Optimierung (source mask polarization wavefront optimization SMPWO) umfasst.

8. Verfahren nach einem der vorhergehenden Ansprüche,
**dadurch gekennzeichnet, dass**
das Verfahren einen Schritt der Erfassung sämtlicher weiterer Manipulatoren und der Bestimmung des gesamten Manipulationsbereichs der Manipulatoren umfasst.

9. Verfahren nach einem der vorhergehenden Ansprüche,
**dadurch gekennzeichnet, dass**
die Manipulationsbereiche der weiteren Manipulatoren für verschiedene Abbildungsfehler, insbesondere entsprechend verschiedener Zernike - Polynome bestimmt werden, wobei insbesondere die weiteren Manipulatoren der Projektionsbelichtungsanlage zur Manipulation der Wellenfront bei der Optimierung der ersten Abbildungseigenschaft für mehrere Abbildungsfehler gemäß der Zernike - Polynome in der Mittellage des Manipulationsbereichs eingestellt werden.
